# EUROPEAN PATENT APPLICATION

(11) **EP 4 654 757 A2**
(43) Date of publication of application: **26.11.2025**
(21) Application number: 25174388.6
(22) Date of filing: 06.05.2025
(51) Int. Cl.: H05K 1/03, H05K 1/18, H05K 3/00, H05K 3/46

(54) **REINFORCING PLATE AND ELECTRICAL COMPONENT**

(30) Priority: 22.05.2024 JP 2024083588
(71) Applicant: MEKTEC CORPORATION, Tokyo 105-8585 (JP)
(72) Inventor: SAIGUSA, Masaya, Tokyo 105-8585 (JP); AITA, Hironori, Tokyo 105-8585 (JP); KIYOMOTO, Shuichi, Tokyo 105-8585 (JP)
(74) Representative: Zimmermann, Tankred Klaus

(57) **Abstract**

A reinforcing plate to be bonded to a flexible printed circuit board, the reinforcing plate having heat resistance sufficient to withstand a reflow soldering process and configured to include a molded article made of a thermoplastic resin. An electrical component includes the reinforcing plate and the flexible printed circuit board to which the reinforcing plate is bonded.

## Description

### BACKGROUND

### 1. Technical Field

One aspect of the present disclosure relates to a reinforcing plate and an electrical component.

### 2. Related Art

For an electrical component including a flexible printed circuit board (hereinafter referred to as "FPC"), a technique is known for attaching various electronic components and connectors to the FPC by reflow soldering. The FPC itself is highly flexible. Therefore, a reinforcing plate is generally attached to a rear surface of a site of the FPC where the various electronic components and connectors are attached. A glass epoxy material having excellent heat resistance is widely used as a material of the reinforcing plate.

Typically, a glass epoxy reinforcing plate is manufactured into a desired shape by punching with a mold, either before or after it is bonded to the FPC. When such punching is performed, a large burr can be created in a cut area and cutting powder is generated. These things may have a negative effect on the electrical component. Furthermore, when the reinforcing plate is made of glass epoxy, it is difficult to process the reinforcing plate in a thickness direction thereof. Therefore, it is difficult to process the reinforcing plate into a complex three-dimensional shape. Prior literature on this technology includes, for example, Japanese Patent No. 3895125.

### SUMMARY

A reinforcing plate to be bonded to a flexible printed circuit board, the reinforcing plate having heat resistance sufficient to withstand a reflow soldering process and configured to include a molded article made of a thermoplastic resin.

### BRIEF DESCRIPTION OF THE DRAWINGS

Figs. 1A to 1C are schematic diagrams of electrical component according to an example of the present disclosure;
Figs. 2A and 2B are schematic diagrams of a reinforcing plate according to the example of the present disclosure and
Figs. 3A to 3C are schematic diagrams of the reinforcing plate according to the example of the present disclosure.

### DETAILED DESCRIPTION

In the following detailed description, for purpose of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

An object of the present disclosure is to provide a reinforcing plate that can be formed into a complex three-dimensional shape without the need for punching, and an electrical component including the reinforcing plate.

That is, according to one aspect of the present disclosure, a reinforcing plate to be bonded to a flexible printed circuit board has heat resistance sufficient to withstand a reflow soldering process and is configured to include a molded article made of a thermoplastic resin.

Further, according to one aspect of the present disclosure, an electrical component includes: the reinforcing plate; and the flexible printed circuit board to which the reinforcing plate is bonded.

According to these aspects, the present reinforcing plate is configured to include a molded article made of a thermoplastic resin. Therefore, the present reinforcing plate can be formed without punching, and can be formed to have a complex three-dimensional shape. In addition, the present reinforcing plate has heat resistance sufficient to withstand a reflow soldering process. Therefore, even in a case where the reinforcing plate is bonded to the flexible printed circuit board, and then various electronic components and/or connectors or the like are attached to the flexible printed circuit board by reflow soldering, occurrence of defects in the reinforcing plate can be suppressed.

An arithmetic mean roughness Ra of a bonding surface of the present reinforcing plate to the flexible printed circuit board is preferably 5 (µm) or more.

This allows the present reinforcing plate to be bonded suitably to the flexible printed circuit board.

It is preferred that a groove is provided on a bonding surface of the reinforcing plate to the flexible printed circuit board, and when a thermosetting adhesive for bonding the reinforcing plate and the flexible printed circuit board flows, the groove stores the thermosetting adhesive that flows.

Thus, when the present reinforcing plate is bonded to the flexible printed circuit board, it is possible to suppress the thermosetting adhesive that flows from overflowing from a gap between the flexible printed circuit board and the present reinforcing plate. Note that in a case where the reinforcing plate is made of glass epoxy, it is difficult to form such a groove. In contrast, the present reinforcing plate is configured to include the molded article made of the thermoplastic resin. This makes it easy to form such a groove in the present reinforcing plate.

It is preferred that the reinforcing plate includes an engaged portion configured as a step formed in a thickness direction of the reinforcing plate, and the engaged portion is configured to engage with an engaging protrusion provided on an attachment member to be attached to the flexible printed circuit board.

This allows the attachment member to be attached to the flexible printed circuit board by engaging the engaging protrusions provided on the attachment member with the engaged portion provided on the present reinforcing plate. Note that in a case where the reinforcing plate is made of glass epoxy, it is difficult to provide the above-mentioned step in the reinforcing plate. Therefore, in a case of using the reinforcing plate to attach the attachment member to the flexible printed circuit board, fasteners such as bolts and nuts were required. In contrast, the present reinforcing plate is configured to include the molded article made of the thermoplastic resin. Therefore, it is easy to provide the above-mentioned step in the reinforcing plate. Therefore, by using this step as the engaged portion, the attachment component can be easily attached to the flexible printed circuit board.

Note that each of configurations described above can be employed in combination as much as possible.

As described above, the present reinforcing plate according to the aspects of the present disclosure can be formed without punching, and can be formed to have a complex three-dimensional shape.

An embodiment for implementing this disclosure will be illustratively described in detail based on an example with reference to the drawings below. However, dimensions, materials, shapes, and relative positions of components described in this example do not limit the technical scope of this disclosure unless there is a specific description.

### (Example)

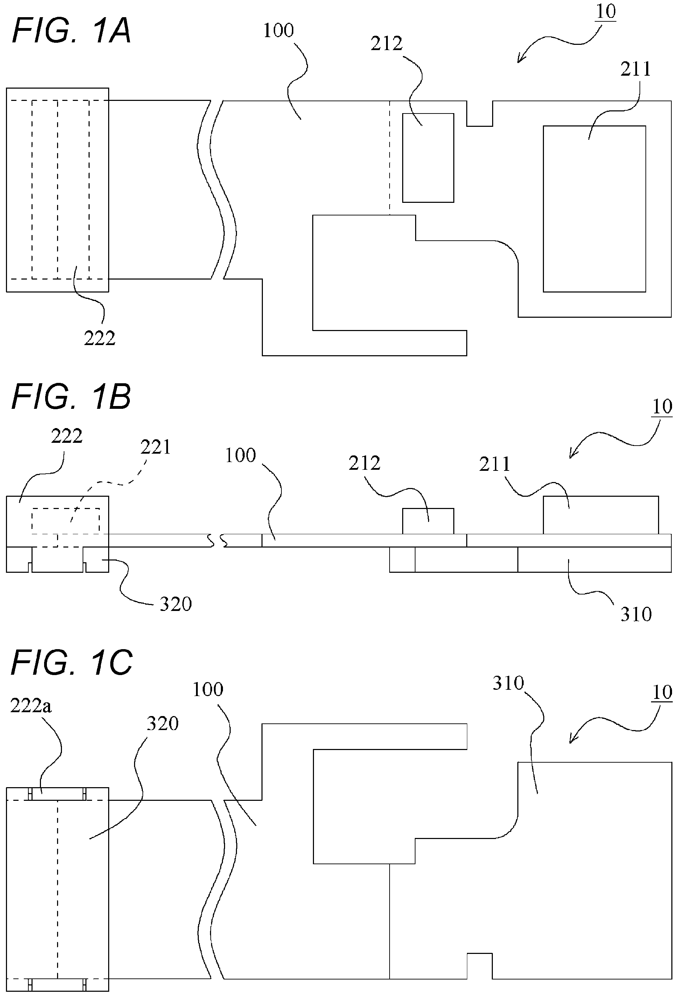

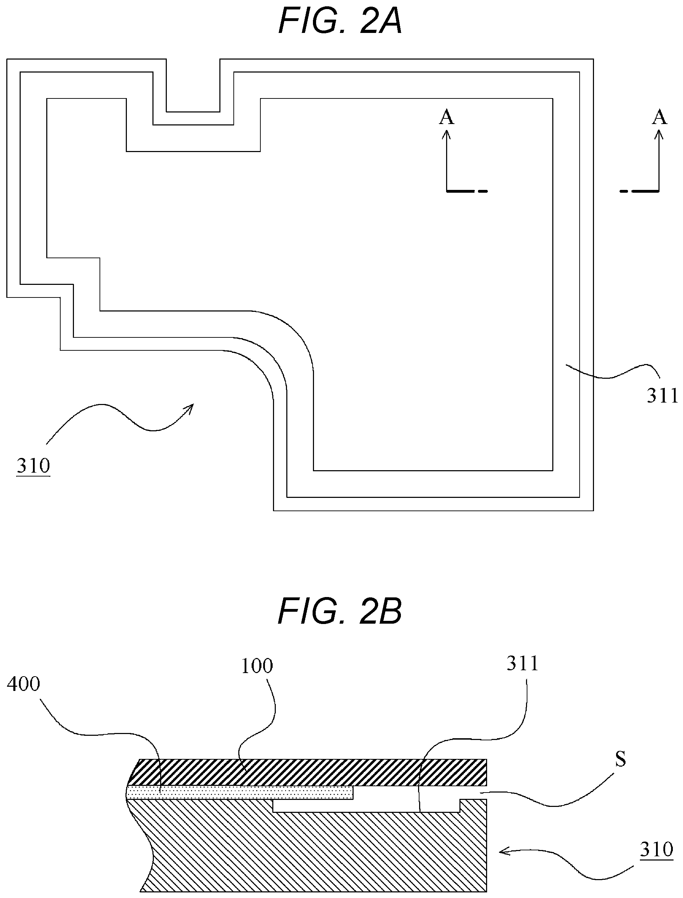

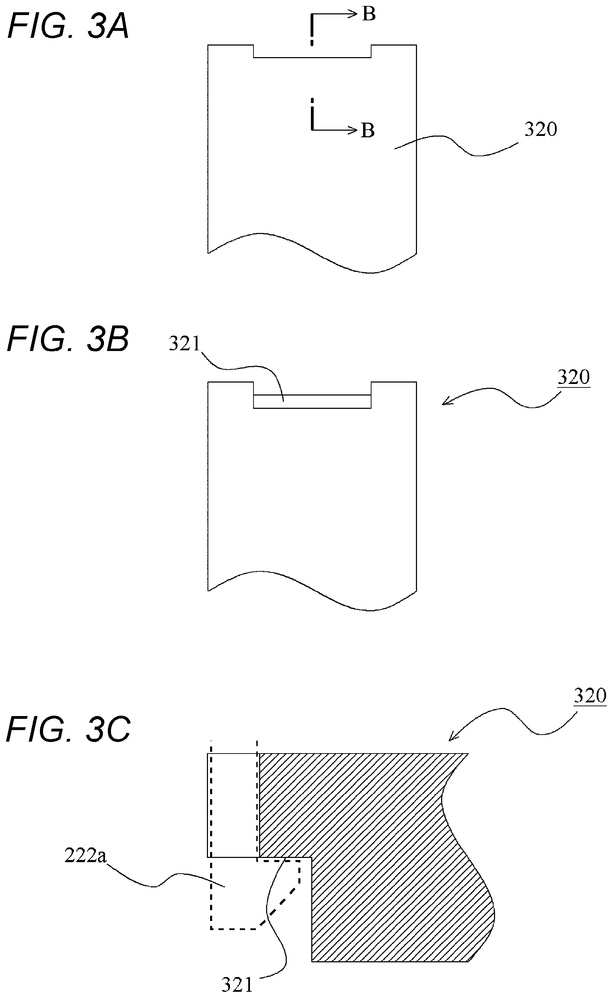

The electrical component and the reinforcing plate according to the example of the present disclosure will be described with reference to Figs. 1A to 3C. Figs. 1A to 1C are schematic diagrams of the electrical component according to the example of the present disclosure, Fig. 1A is a plan view of the electrical component, Fig. 1B is a side view of the electrical component, and Fig. 1C is a bottom view of the electrical component. In Figs. 1A to 3C, internal or rear surface side members are illustrated by dotted lines in a see-through manner as appropriate. Figs. 2A and 2B are schematic diagrams of the reinforcing plate according to the example of the present disclosure, Fig. 2A is a plan view of the reinforcing plate, and Fig. 2B is a sectional view (a sectional view taken along line A-A in Fig. 2A) of the reinforcing plate. Figs. 3A to 3C are schematic diagrams illustrating a portion of the reinforcing plate according to the example of the present disclosure, Fig. 3A is a plan view of the reinforcing plate, Fig. 3B is a bottom view of the reinforcing plate, and Fig. 3C is a sectional view (a sectional view taken along line B-B in Fig. 3A) of the reinforcing plate. Note that in the drawings, in order to make configuration of members easier to understand, dimensional relationships between the components (particularly dimensional relationships in a thickness direction) are different from those of typical actual products.

### <Electrical component>

An electrical component 10 according to this example includes a flexible printed circuit board 100 (hereinafter referred to as "FPC 100"), electronic components 211 and 212 mounted on a surface of the FPC 100, and a connector 221 and a connector cover 222 attached to an end of the FPC 100. The electrical component 10 includes a first reinforcing plate 310 and a second reinforcing plate 320. The first reinforcing plate 310 is provided on a rear surface of an area of the FPC 100 where the electronic components 211 and 212 are arranged. The second reinforcing plate 320 is provided on a rear surface of an area of the FPC 100 where the connector 221 is disposed.

In manufacturing the electrical component 10 configured as described above, the FPC 100 is first produced. As the FPC 100 is a publicly known technology, it will be briefly described here. First, a desired circuit is formed by etching a metal foil (such as a copper foil) provided on a surface of a base film. Thereafter, a cover film is provided on the base film so as to cover the circuit. Further thereafter, the base film is cut into a desired shape to obtain the FPC 100. The first reinforcing plate 310 and the second reinforcing plate 320 are bonded to the FPC 100 obtained in this manner with a thermosetting adhesive.

Then, the electronic components 211 and 212 and the connector 221 are mounted on the surface of the FPC 100. More specifically, some of circuits are exposed from an opening provided in the cover film. Current-carrying parts of the electronic components 211 and 212 and a current-carrying part of the connector 221 are respectively connected to the exposed circuits by reflow soldering (soldering in a reflow furnace). This reflow process allows the electronic components 211 and 212 and the connector 221 to be mounted on the FPC 100 at the same time. Thereafter, the connector cover 222 is attached to the FPC 100, so that the electrical component 10 can be obtained.

### <Reinforcing plate>

The reinforcing plates (The first reinforcing plate 310 and the second reinforcing plate 320) have heat resistance sufficient to withstand the reflow soldering process and are configured to include the molded article made of the thermoplastic resin. In this example, the reinforcing plates (the first reinforcing plate 310 and the second reinforcing plate 320) are substantially constituted by the molded article made of the thermoplastic resin. An example of the thermoplastic resin having heat resistance sufficient to withstand the reflow soldering process is polyphthalamide (PPA). Note that heating is performed at, for example, 260°C in reflow soldering, and thus a material used for the reinforcing plate preferably has heat resistance of 260°C or higher. Since the polyphthalamide has heat resistance of 280°C or higher, it can withstand heat even in the reflow soldering process.

In this way, the first reinforcing plate 310 and the second reinforcing plate 320 according to this example are configured to include the molded article made of the thermoplastic resin. Therefore, not only can planar shapes of these reinforcing plates be freely designed, but a certain degree of design freedom is also ensured in the thickness direction of these reinforcing plates. As described above, the first reinforcing plate 310 and the second reinforcing plate 320 are bonded to the FPC 100 with the thermosetting adhesive. Then, in this example, the first reinforcing plate 310 and the second reinforcing plate 320 are configured so that the arithmetic mean roughness Ra of bonding surfaces of these reinforcing plates to the FPC 100 is 5 (µm) or more. For example, the arithmetic mean roughness of a desired portion on the reinforcing plate can be made Ra5 (µm) or more by applying emboss processing by etching or the like to a surface of a mold for molding the reinforcing plate (a mold surface for forming a cavity).

### <<First reinforcing plate>>

The first reinforcing plate 310 will be described in more detail with reference to Figs. 2A and 2B. A bonding surface of the first reinforcing plate 310 to the FPC 100 is provided with a groove 311 at a position slightly away from an outer periphery of the first reinforcing plate 310 so as to follow an outer shape of the first reinforcing plate 310. The groove 311 is provided to store a thermosetting adhesive 400 that flows when the thermosetting adhesive 400 for bonding the first reinforcing plate 310 and the FPC 100 flows. That is, when the first reinforcing plate 310 is bonded to the FPC 100, the thermosetting adhesive 400 is first applied to a portion of the FPC 100 where the first reinforcing plate 310 is to be bonded. Then, with the first reinforcing plate 310 positioned relative to the FPC 100, the FPC 100 and the first reinforcing plate 310 are heated and pressurized to sandwich the thermosetting adhesive 400. Thus, the thermosetting adhesive 400 becomes fluid and then hardens. Thus, the first reinforcing plate 310 is adhered to the FPC 100 and bonded together. In this way, during a process of bonding the first reinforcing plate 310 to the FPC 100, since the thermosetting adhesive 400 becomes fluid, the thermosetting adhesive 400 flows to spread outward. Thus, there is a possibility that a part of the thermosetting adhesive 400 overflows from a gap S between the FPC 100 and the first reinforcing plate 310. However, in this example, the thermosetting adhesive 400 that flows to spread outward is stored in the groove 311. Therefore, it is possible to suppress a portion of the thermosetting adhesive 400 from overflowing from the gap S between the FPC 100 and the first reinforcing plate 310.

### <<Second reinforcing plate>>

The second reinforcing plate 320 will be described in more detail with reference to Figs. 1A to 1C and 3A to 3C. As described above, the electrical component 10 according to this example is provided with the connector cover 222 as the attachment member to be attached to the FPC 100. Then, the second reinforcing plate 320 is provided with an engaged portion 321 configured as a step formed in the thickness direction, and the connector cover 222 is provided with an engaging protrusion 222a that engages with the engaged portion 321. That is, the engaged portion 321 is configured to be engaged with the engaging protrusion 222a provided on the connector cover 222 attached to the FPC 100. In Fig. 3C, the engaging protrusion 222a engaged with the engaged portion 321 is illustrated by a dotted line. In this way, in this example, the connector cover 222 can be easily attached to the FPC 100 by engaging the engaging protrusion 222a with the engaged portion 321.

Although not specifically illustrated, the second reinforcing plate 320 is also preferably provided with a groove capable of storing the thermosetting adhesive that flows, similar to the first reinforcing plate 310.

### <Advantages of electrical component and reinforcing plate according to this example>

According to this example, the reinforcing plates (the first reinforcing plate 310 and the second reinforcing plate 320) are configured to include the molded article made of the thermoplastic resin. Therefore, punching is not required when manufacturing the reinforcing plate. Further, the reinforcing plate can also be formed to have a complex three-dimensional shape. Furthermore, the reinforcing plate has heat resistance sufficient to withstand the reflow soldering process. Therefore, even in a case where the reinforcing plate is bonded to the FPC 100, and then the electronic components 211 and 212 and the connector 221 are attached to the FPC 100 by reflow soldering, the occurrence of the defects in the reinforcing plate can be suppressed. Note that this example shows an example in which the electronic components 211 and 212 and the connector 221 are mounted on the FPC 100. In this regard, it goes without saying that the occurrence of the defects in the reinforcing plate can also be suppressed when other mounting components are attached by reflow soldering.

Further, the arithmetic mean roughness Ra of the bonding surface of the reinforcing plate in this example to the FPC 100 is 5 (µm) or more. This allows a surface area of the bonding surface to be sufficiently wide, and thus it is possible to obtain sufficient adhesive strength between the reinforcing plate and the thermosetting adhesive 400. Therefore, the reinforcing plate can be suitably bonded to the FPC 100.

Further, the groove 311 for storing the thermosetting adhesive 400 that flows is provided on the bonding surface of the first reinforcing plate 310 to the FPC 100. This makes it possible to suppress the thermosetting adhesive 400 that flows from overflowing from the gap S between the FPC 100 and the first reinforcing plate 310 when the first reinforcing plate 310 is bonded to the FPC 100. Note that by providing a similar groove in the second reinforcing plate 320, it is also possible to suppress the thermosetting adhesive that flows from overflowing from the gap between the FPC 100 and the second reinforcing plate 320.

Furthermore, the second reinforcing plate 320 includes the engaged portion 321 configured as a step formed in the thickness direction, and the engaged portion 321 is configured to engage with the engaging protrusion 222a provided on the connector cover 222. This allows the connector cover 222 to be easily attached to the FPC 100 by engaging the engaging protrusion 222a with the engaged portion 321. Note that in this example, the connector cover is shown as an example of the attachment member. In this regard, by adopting a similar configuration for other attachment members, these attachment members can be easily attached to the FPC 100.

The foregoing detailed description has been presented for the purposes of illustration and description. Many modifications and variations are possible in light of the above teaching. It is not intended to be exhaustive or to limit the subject matter described herein to the precise form disclosed. Although the subject matter has been described in language specific to structural features and/or methodological acts, it is to be understood that the subject matter defined in the appended claims is not necessarily limited to the specific features or acts described above. Rather, the specific features and acts described above are disclosed as example forms of implementing the claims appended hereto.

## Claims

1. A reinforcing plate to be bonded to a flexible printed circuit board, the reinforcing plate having heat resistance sufficient to withstand a reflow soldering process and configured to include a molded article made of a thermoplastic resin.

2. The reinforcing plate according to claim 1, wherein an arithmetic mean roughness Ra of a bonding surface of the reinforcing plate to the flexible printed circuit board is 5 µm or more.

3. The reinforcing plate according to claim 1 or 2, wherein a groove is provided on a bonding surface of the reinforcing plate to the flexible printed circuit board, and when a thermosetting adhesive for bonding the reinforcing plate and the flexible printed circuit board flows, the groove stores the thermosetting adhesive that flows.

4. The reinforcing plate according to any one of claims 1 to 3, comprising an engaged portion configured as a step formed in a thickness direction of the reinforcing plate, wherein
the engaged portion is configured to engage with an engaging protrusion provided on an attachment member to be attached to the flexible printed circuit board.

5. An electrical component comprising:
the reinforcing plate according to any one of claims 1 to 4; and
the flexible printed circuit board to which the reinforcing plate is bonded.
